# EUROPEAN PATENT SPECIFICATION

(11) **EP 2 738 203 B1**
(45) Date of publication and mention of the grant of the patent: **18.04.2018**
(21) Application number: 13155467.7
(22) Date of filing: 15.02.2013
(51) Int. Cl.: C08K 3/22

(54) **Polyester compositions with improved heat and light aging**
Polyesterzusammensetzungen mit verbesserter Wärme- und Lichtalterung
Compositions de polyester présentant de meilleures propriétés de vieillissement à la chaleur et à la lumière

(30) Priority: 29.11.2012 US 201261731063 P
(43) Date of publication of application: 04.06.2014
(73) Proprietor: Solvay Specialty Polymers USA, LLC., Alpharetta, GA 30005-3914 (US)
(72) Inventor: Bongiovanni, Alessandro, ALPHARETTA, Georgia 30022 (US)
(74) Representative: Benvenuti, Federica

(56) References cited:
- WO-A2-2008/154600
- US-A1- 2012 235 559
- US-A1- 2012 262 927

## Description

### Field of the Invention

The present invention relates to polymeric compositions comprising certain polyesters and at least two different inorganic additives. Those compositions feature a very good retention of light reflectance after heat and light aging and are well suited for the manufacture of light emission apparatuses.

The present invention further provides an article comprising the composition of the invention, such as a part of a light emission apparatus, and in particular of a light emitting diode (LED) device.

### Background of the Invention

LEDs are increasingly being used as light sources in numerous applications due to the high number of benefits they provide over traditional light sources. LEDs generally consume significantly less power than other light sources, require a low voltage to operate, and are resistant to mechanical shock. As a result, they are displacing incandescent and other light sources in many uses and have found applications in such disparate areas as traffic signals, interior and exterior lighting, cellular telephone displays, automotive displays and flashlights.

LED components, such as reflectors, require an especially demanding combination of excellent color and improved physical properties. Ceramics may be advantageously used in those applications, but are still extremely costly and require demanding processing technologies. Therefore, polymers have been extensively studied and developed to replace ceramics as a lower cost material. A great benefit of thermoplastic polymers is that they may be injection molded and therefore offer considerable design flexibility. One problem noted with the polymer compositions used for the manufacture of LED components is that they tend to yellow when exposed to light and elevated temperatures. For example, during manufacturing, the LED components are heated to about 180°C to cure an epoxy or silicon encapsulant. The LED components are also exposed to temperatures above 260°C while soldering operations are performed. In addition, while in use, LED components are routinely subjected to light and temperatures above 80°C. Moreover, the recent development of higher voltage LEDs leads to even higher working temperatures, generally above 100°C. This concurrent exposure to light and high temperatures causes yellowing of polymer compositions used for forming LED components.

Desirably, reflectors of LEDs and, *in fine*, the polymer compositions from which they are made, should comply with a wide set of requirements, including, notably, high reflectance of light, high whiteness, high dimensional stability, high mechanical strength, high heat deflection temperature, and high heat resistance (low discoloration and low loss of reflectance when exposed to high temperatures) while being easily processed into the desired shapes.

Polyesters are often used to manufacture shaped articles for use in a wide range of applications, including films, sheets, profiles, bottles, and the like. The most commonly used polyesters are based on terephthalic acid or 2,6-naphthalene dicarboxylic acid, and include, for example, poly(ethylene terephthalate) ("PET"), poly(1,4-butylene terephthalate) ("PBT"), poly(cyclohexylenedimethylene terephthalate) ("PCT"), poly(cyclohexylenedimethylene naphthalate) ("PCN"), poly(ethylene naphthalate) ("PEN") and their copolyesters. These polyesters are relatively inexpensive, widely available and, because of their aromatic content, have a high glass transition temperature (Tg), which gives shaped articles made there from thermal resistance, stiffness and toughness.

In spite of these positive characteristics, certain polyesters (and notably PCT) possess some limitations in applications such as LEDs where the materials are exposed to heat and light on the long term.

WO 2007/033129 discloses light-emitting diode assembly housings comprising PCT compositions comprising titanium dioxide, inorganic reinforcing agents or fillers, and oxidative stabilizers. Those compositions suffer from a very low whiteness index even after very mild heat treatment.

US 2012/0262927 relates to compositions suitable for molding LED reflectors comprising PCT, a white pigment and a reactive viscosity stabilizer such as a phenoxy resin or a non-aromatic epoxy resin. US'927 discloses in its examples PCT compositions comprising titanium dioxide, chopped glass fibers, 2 wt. % of talc and 8 other additives. Those compositions only achieve a maximum of about 84 % of whiteness index retention after only 4 hours at 200°C.

One of ordinary skill in the art will recognize that further improvements in reflectance retention even after long term heat and light exposure are advantageous for the development of LED devices.

The inventor has discovered that the presence of certain metal oxides greatly enhances the behavior of certain white pigmented polyester compositions in terms of reflectance retention after heat and light exposure.

The polyester compositions according to the present invention satisfy thus the above-mentioned requirements and will be described in detail hereafter.

### Summary of the Invention

In a first aspect, the present invention relates to a polymer composition (C) comprising :
- at least one polyester (P) comprising at least 50 mol % of recurring units comprising at least one cycloaliphatic group,
- at least one first inorganic additive, inorganic additive (A) selected from the group consisting of TiO₂, ZnS₂ and BaSO₄,
- from 0.2 to 10 wt.%, based on the total weight of the polymer composition (C), of at least one second inorganic additive, inorganic additive (B) selected from the group consisting of aluminum oxide, magnesium oxide, barium oxide, zinc oxide, cerium oxide (IV) and calcium oxide.

In a second aspect, the present invention relates to articles comprising at least one part comprising the invented polymer composition (C) and, in particular, to parts of LED devices made from such polymer composition (C).

### Detailed Description of the Invention

The polymer composition (C) according to the present invention comprises three essential ingredients that are described in detail here below :

### The polyester (P)

The term "polyester" is intended to include "copolyesters" and is understood to denote a polymer comprising at least 50 mol %, preferably at least 85 mol % of recurring units comprising at least one ester moiety (commonly described by the formula : R-(C=O)-OR'). Polyesters may be obtained by ring opening polymerization of a cyclic monomer (M_{A}) comprising at least one ester moiety ; by polycondensation of a monomer (M_{B}) comprising at least one hydroxyl group and at least one carboxylic acid group, or by polycondensation of at least one monomer (M_{C}) comprising at least two hydroxyl groups (a diol) and at least one monomer (M_{D}) comprising at least two carboxylic acid groups (a dicarboxylic acid). As used herein, the term dicarboxylic acid is intended to include dicarboxylic acids and any derivative of dicarboxylic acids, including their associated acid halides, esters, half-esters, salts, half-salts, anhydrides, mixed anhydrides, or mixtures thereof.

The polyester (P) comprises at least 50 mol %, preferably at least 60 mol %, more preferably at least 70 mol %, still more preferably at least 80 mol % and most preferably at least 90 mol % of recurring units comprising, in addition to the at least one ester moiety, at least one cycloaliphatic group. Excellent results were obtained when the polyester (P) was essentially composed of recurring units comprising at least one ester moiety and at least one cycloaliphatic group. The cycloaliphatic group may derive from monomers (M_{A}), monomers (M_{B}), monomers (M_{C}) or monomers (M_{D}) comprising at least one group which is both aliphatic and cyclic.

Non limitative examples of monomers (M_{A}) include lactide and caprolactone.

Non limitative examples of monomers (M_{B}) include glycolic acid, 4-hydroxybenzoic acid and 6-hydroxynaphthalene-2-carboxylic acid.

Non limitative examples of monomers (M_{C}) include 1,4-cyclohexanedimethanol, ethylene glycol, 1,2-propanediol, 1,3-propanediol, 1,4-butanediol, 1,5-pentanediol, 1,6-hexanediol, 1,8-octanediol, 1,10-decanediol, 2,2,4-trimethyl 1,3-pentanediol, 2,2,4,4-tetramethyl-1,3-cyclobutanediol, and neopentyl glycol, while 1,4-cyclohexanedimethanol and neopentyl glycol are preferred.

Non limitative examples of monomers (M_{D}) include terephthalic acid, isophthalic acid, naphthalene dicarboxylic acids, 1,4-cyclohexane dicarboxylic acid, succinic acid, sebacic acid, and adipic acid, while terephthalic acid and 1,4-cyclohexane dicarboxylic acid are preferred.

When the polyester (P) is a copolymer, monomers (M_{C}) and (M_{D}) are preferably used. In such a case, monomer (M_{C}) is preferably 1,4-cyclohexanedimethanol and monomer (M_{D}) is preferably a mixture of terephthalic acid and 1,6-naphthalene dicarboxylic acid.

When the polyester (P) is a homopolymer, it may be selected from poly(cyclohexylenedimethylene terephthalate) ("PCT") and poly(cyclohexylenedimethylene naphthalate) ("PCN"). Most preferably, it is PCT (i.e. a homopolymer obtained through the polycondensation of terephthalic acid with 1,4-cyclohexylenedimethanol).

The polyester (P) has advantageously an intrinsic viscosity of from about 0.4 to about 2.0 dl/g as measured in a 60:40 phenol/tetrachloroethane mixture or similar solvent at about 30°C. Particularly suitable polyester (P) for this invention has an intrinsic viscosity of 0.5 to 1.4 dl/g.

The polyester (P) has a melting point, as measured by DSC according to ISO-11357-3, of advantageously at least 250°C, preferably at least 260°C, more preferably at least 270°C and most preferably at least 280°C. Besides, its melting point is advantageously of at most 350°C, preferably at most 340°C, more preferably at most 330°C and most preferably at most 320°C. Excellent results were obtained with a polyester (P) having a melting point ranging from 280°C to 320°C.

The polyester (P) is preferably present in an amount of at least 40 wt. %, more preferably at least 45 wt. %, still more preferably at least 47 wt. %, and most preferably at least 48 wt. %, based on the total weight of the polymer composition (C).

The polyester (P) is also present in an amount of advantageously at most 80 wt. %, preferably at most 75 wt. %, more preferably at most 70 wt. %, still more preferably at most 65 wt. %, and most preferably at most 60 wt. %, based on the total weight of the polymer composition (C).

Excellent results were obtained when the polyester (P) was present in the polymer composition (C) in an amount from about 45 to about 60 wt. %, preferably from about 48 to about 58 wt. %, based on the total weight of the polymer composition (C).

### The inorganic additive (A)

The polymer composition (C) also comprises at least one inorganic additive (A) selected from the group consisting of TiO₂, ZnS₂ and BaSO₄.

The inorganic additive (A) is advantageously in the form of particles having a weight-average size (equivalent diameter) preferably of below 1 µm. Preferably, the weight-average size of the particles is of below 0.8 µm. Besides, it is preferably above 0.1 µm.

The shape of the particles is not particularly limited ; they may be notably round, flaky, flat, and so on.

The inorganic additive (A) is preferably titanium dioxide (TiO₂). The form of titanium dioxide is not particularly limited and a variety of crystalline forms such as the anatase form, the rutile form, and the monoclinic type can be used. However, the rutile form is preferred due to its higher refraction index and its superior light stability. Titanium dioxide may or may not be treated with a surface treatment agent. Preferably the weight-average particle size of the titanium oxide is in the range of 0.15 µm to 0.35 µm.

The surface of the titanium dioxide particles will preferably be coated. The titanium dioxide will preferably be first coated with an inorganic coating and then with an organic coating. The titanium dioxide particles may be coated using any method known in the art. Preferred inorganic coatings include metal oxides. Organic coatings may include one or more of carboxylic acids, polyols, alkanolamines, and/or silicon compounds.

The inorganic additive (A) is preferably present in an amount of at least 1 wt. %, preferably of at least 6 wt. %, more preferably of at least 8 wt. %, even more preferably of at least 10 wt. %, and most preferably of at least 15 wt. %, based on the total weight of the polymer composition (C). Besides, the inorganic additive (A) is also preferably present in an amount of at most 50 wt. %, preferably of at most 45 wt. %, more preferably of at most 40 wt. %, even more preferably of at most 35 wt. %, and most preferably of at most 30 wt. %, based on the total weight of the polymer composition (C).

Excellent results were obtained when titanium dioxide was used in an amount of 10-40 wt. %, preferably of 15-35 wt. %, based on the total weight of the polymer composition (C).

### The inorganic additive (B)

The polymer composition (C) further comprises at least one inorganic additive (B), different from the above detailed inorganic additive (A), selected from the group consisting of aluminum oxide, magnesium oxide, barium oxide, zinc oxide, cerium oxide (IV) and calcium oxide.

The inorganic additive (B) is preferably selected from the group consisting of aluminum oxide, magnesium oxide, zinc oxide, cerium oxide (IV) and calcium oxide. Excellent results were obtained when using magnesium oxide and calcium oxide.

The inorganic additive (B) is present in an amount of from 0.2 wt. % to 10 wt.% base on the total weight of the polymer composition (C). The inorganic additive (B) is preferably present in an amount of at least 0.4 wt. %, more preferably of at least 0.5 wt. %, even more preferably of at least 1 wt. % and most preferably of at least 2 wt. %, based on the total weight of the polymer composition (C). Besides, the inorganic additive (B) is preferably present in an amount of at most 8 wt. %, more preferably of at most 6 wt. %, even more preferably of at most 5 wt. %, and most preferably of at most 4 wt. %, based on the total weight of the polymer composition (C).

Excellent results were obtained when the inorganic additive (B) was used in an amount of 0.2-5 wt. %, preferably of 0.5-4 wt. %, based on the total weight of the polymer composition (C).

### Optional ingredients

The polymer composition (C) may also further comprise at least another polyester, different from the above mentioned polyester (P), which may be selected from the group consisting of: polyglycolide or polyglycolic acid (PGA), polylactic acid (PLA), polycaprolactone (PCL), polyethylene adipate (PEA), polyhydroxyalkanoate (PHA), polybutylene terephthalate (PBT), polypropylene terephthalate (PPT), polytrimethylene terephthalate (PTT), polyethylene naphthalate (PEN), polybutylene naphthalate (PBN), polyethylene terephthalate (PET), and Liquid Crystalline Polyesters (LCP). It is preferably selected from the group consisting of PBT, PTT, PEN, PET and LCP. More preferably, it is selected from the group consisting of PBT and LCP.

When added to the polymer composition (C), the other polyester different from the polyester (P) is preferably present in an amount of at least 1 wt. %, preferably of at least 2 wt. %, more preferably of at least 3 wt. %, even more preferably of at least 4 wt. %, and most preferably of at least 5 wt. %, based on the total weight of the polymer composition (C). Besides, the other polyester is also preferably present in an amount of at most 20 wt. %, preferably of at most 15 wt. %, more preferably of at most 10 wt. %, even more preferably of at most 9 wt. %, and most preferably of at most 8 wt. %, based on the total weight of the polymer composition (C).

The polymer composition (C) may also comprise other polymers than the above mentioned polyesters such as polycarbonate, polyethylene glycol, polysulfone, PEEK, PTFE and polyphthalamide.

The polymer composition (C) may also further comprise at least one reinforcing filler.

Reinforcing fillers are preferably fibrous. More preferably, the reinforcing filler is selected from glass fiber, carbon fiber, synthetic polymeric fiber, aramid fiber, aluminum fiber, titanium fiber, magnesium fiber, boron carbide fibers, rock wool fiber, steel fiber, wollastonite, etc. Still more preferably, it is selected from glass fiber and wollastonite.

A particular class of fibrous fillers consists of whiskers, i.e. single crystal fibers made from various raw materials such as SiC, BC, Fe and Ni. Among fibrous fillers, glass fibers are preferred ; they include chopped strand A-, E-, C-, D-, S- T- and R-glass fibers, as described in chapter 5.2.3, p. 43-48 of Additives for Plastics Handbook, 2nd ed., John Murphy.

Excellent results were obtained when wollastonite and/or glass fibers were used. Glass fibers may have a round cross-section or an elliptic cross-section (also called flat fibers).

If present, the reinforcing filler is preferably present in an amount of at least 2 wt. %, more preferably at least 4 wt. %, still more preferably at least 5 wt. %, and most preferably at least 10 wt. %, based on the total weight of the polymer composition (C). When present, the reinforcing filler is also preferably present in an amount of at most 40 wt. %, more preferably at most 30 wt. %, still more preferably at most 25 wt. %, and most preferably at most 20 wt. %, based on the total weight of the polymer composition (C).

Excellent results were obtained when the reinforcing filler was present in the composition in an amount from about 5 to about 40 wt. %, preferably from about 5 to about 25 wt. %, and more preferably from about 10 to about 20 wt. %, based on the total weight of the polymer composition (C).

The polymer composition (C) can further contain one or more impact modifiers. The impact modifiers can be reactive with the polyester (P) or non-reactive. In certain specific embodiment, the polymer composition (C) contains at least one reactive impact modifier and at least one non-reactive impact modifier.

Reactive impact modifiers that may be used include ethylene-maleic anhydride copolymers, ethylene-alkyl (meth)acrylate-maleic anhydride copolymers, ethylene-alkyl (meth)acrylate-glycidyl (meth)acrylate copolymers, and the like. An example of such reactive impact modifier is a random terpolymer of ethylene, methylacrylate and glycidyl methacrylate.

Non-reactive impact modifiers that may be blended into the polymer composition (C) generally include various rubber materials, such as acrylic rubbers, ASA rubbers, diene rubbers, organosiloxane rubbers, EPDM rubbers, SBS or SEBS rubbers, ABS rubbers, NBS rubbers and the like. Particular examples of non-reactive impact modifiers include ethyl butylacrylate, ethyl (methyl)acrylate or 2 ethyl hexyl acrylate copolymers.

If present, the impact modifier is preferably present in an amount of at least 2 wt. %, more preferably at least 4 wt. %, still more preferably at least 5 wt. %, and most preferably at least 10 wt. %, based on the total weight of the polymer composition (C). When present, the impact modifier is also preferably present in an amount of at most 20 wt. %, more preferably at most 15 wt. %, still more preferably at most 10 wt. %, and most preferably at most 5 wt. %, based on the total weight of the polymer composition (C).

The polymer composition (C) may optionally further contain up to about 3 wt. % of ultraviolet light stabilizers or UV blockers. Examples include triazoles and triazines, oxanilides, hydroxybenzophenones, benzoates, and α-cyanoacrylates. When present, the ultraviolet light stabilizers are preferably present in an amount of about 0.1 to about 3 wt. %, or preferably about 0.1 to about 1 wt. %, or more preferably about 0.1 to about 0.6 wt. %, of the total weight of the polymer composition (C).

The polymer composition (C) may also comprise other optional ingredients such as mold release agents, lubricants, nucleating agents, plasticizers, optical brighteners and other stabilizers, different from the ones described above.

In particular, the polymer composition (C) may comprise talc as a nucleating agent. When present, the talc is preferably present in an amount of about 1 to about 5 wt. %, or preferably about 2 to about 4 wt. %, or more preferably about 3 wt. %, of the total weight of the polymer composition (C).

As described above, the polymer composition (C) has excellent reflectance properties. For example, the polymer composition (C) can have an initial reflectance at 460 nm of greater than about 85 %, preferably greater than about 86 %, more preferably greater than about 88 %, still more preferably greater than about 90 % and most preferably greater than 91 %, as measured according to ASTM E-1331-09 using a D65 illuminant with a 10° observer.

The polymer composition (C) has also excellent reflectance properties after long term exposure to high heat and light. For example, the polymer composition (C) can have, after 12 days under light and at 180°C, a reflectance at 460 nm of greater than about 55 %, preferably greater than about 56 %, more preferably greater than about 58 %, still more preferably greater than about 60 %, as measured according to ASTM E-1331-09 using a D65 illuminant with a 10° observer.

Any melt-mixing method may be used to combine the polymeric components and non-polymeric ingredients to prepare the polymer composition (C). For example, the polymeric components and non-polymeric ingredients may be added to a melt mixer, such as, for example, a single or twinscrew extruder, a blender or a Banbury mixer, either all at once through a single step addition, or in a stepwise fashion, and then melt-mixed. When adding the polymeric components and non-polymeric ingredients in a stepwise fashion, part of the polymeric components and/or non-polymeric ingredients are first added and melt-mixed with the remaining polymeric components and non-polymeric ingredients are subsequently added and further melt-mixed until a well-mixed composition is obtained.

An aspect of the present invention also provides an article comprising at least one part comprising the polymer composition (C), which provides various advantages over prior art parts and articles, in particular an increased resistance to concurrent exposure to heat and light while maintaining all their other properties at a high level.

In a particular embodiment, the article is a light emission apparatus.

Non limitative examples of light emission apparatuses are keyless entry systems of an automobile, lightings in a refrigerator, liquid crystal display apparatuses, automobile front panel lighting apparatuses, desk lamps, headlights, household electrical appliance indicators and outdoor display apparatuses such as traffic signs, and optoelectronic devices comprising at least one semi-conductor chip that emits and/or transmits electromagnetic radiation commonly known as Light Emitting Diodes devices (LEDs). Preferably, the light emission apparatus is a LED device.

As used herein, the terms "light emitting diode device" and "LED device" intend to denote a device comprising at least one light emitting diode, an electrical connection capable of connecting the diode to an electrical circuit, and a housing partially surrounding the diode. The LED device may optionally have a lens that fully or partially covers the LED.

LEDs are preferably chosen from the group of top view LEDs, side view LEDs and power LEDs. The top view LEDs are notably used in automotive lighting applications such as panel displays, stop lights and turn signals. The side view LEDs are notably used for mobile appliance applications such as, for example, cell phones and PDAs. The power LEDs are notably used in flashlights, automotive day light running lights, signs and as backlight for LCD displays and TVs.

The articles of the present invention may be incorporated into LED devices used in applications such as traffic signals, large area displays, video screens, interior and exterior lighting, cellular telephone display backlights, automotive displays, vehicle brake lights, vehicle head lamps, laptop computer display backlights, pedestrian floor illumination and flashlights.

The articles of the present invention are preferably parts of a LED device such as housings, reflectors and heatsinks.

The articles prepared from the polymer composition (C) may be manufactured by any suitable melt-processing method known to those skilled in the art, such as injection molding or the like.

The articles may be overmolded over a metal (such as copper or silver-coated copper) lead frame that can be used to make an electrical connection to an LED inserted into the housing. The article preferably has a cavity in the portion of the housing that surrounds the LED, which serves to reflect the LED light in the outward direction and towards a lens, if one is present. The cavity may be in a cylindrical, conical, parabolic or other curved form, and preferably has a smooth surface. Alternatively, the walls of the cavity may be parallel or substantially parallel to the diode. A lens may be formed over the diode cavity and may comprise an epoxy or silicone material.

Preferably at least 50 wt. % and more preferably more than 80 wt. % of the part comprises the polymer composition (C) (the part can possibly further contain notably a metal; for example, for certain end uses, the surface of the part acting as reflector may be metal plated). More preferably, more than 90 wt. % of the part comprises the polymer composition (C). Still more preferably, the part consists essentially of the polymer composition (C). The most preferably, the part consists of the polymer composition (C).

### EXAMPLES

The disclosure will now be illustrated with working examples, which are intended to illustrate the present invention and are not intended to restrictively imply any limitations on the scope of the present disclosure.

The following commercially available materials were used :
*Polyester :* PCT Polyester from Eastman™ Chemical Products
*Reinforcing filler : E-glass fiber* commercially available from OCV™ Reinforcements as OCV 995
*Inorganic additive (A) :* Titanium Dioxide TIPAQUE® PF691 available from Ishihara Sangyo Kaisha, Ltd - rutile TiO₂.
*Inorganic additive (B) :*
   CaO : Calcium oxide available from Atlantic Equipment Engineers as CA 602
   MgO : Magnesium oxide available from Kyowa Chemical Industry Co Ltd as Kyowamag MF-150
*Stabilizers :* the same amounts of two stabilizers were used throughout the experiments, namely Hostanox® P-EPQ and Nylostab® S-EED both commercially available from Clariant™.
*Additives :*
   Talc : talc commercially available from IMI Fabi™ talc as HTP4.
   Lubricant: LLDPE commercially available from the Dow Chemical Company as LLDPE GRSN-9820

### General procedure for the preparation of the compositions

The polyester resin described above was fed to the first barrel of a ZSK-26 twin screw extruder comprising 12 zones via a loss in weight feeder. The barrel set-point temperatures were in the range of 150-300°C and the resins were melted before zone 5. The other solid ingredients were fed at zone 5 through a side stuffer via a loss in weight feeder. The liquid ingredients were fed at zone 7. The screw rate was in the range of 150-200 rpm. The extrudates were cooled and pelletized using conventional equipment.

The nature and quantity of the various ingredients used are summarized in Table 1, indicating the amount of each ingredient in weight percent.

**Table 1 : Nature and quantity in weight % of the ingredients used**

| | (CE1) | **(E2)** | **(E3)** | **(E4)** |
|---|---|---|---|---|
| **Polyester** | 55.30 | **52.30** | **52.30** | **54.80** |
| **Reinforcing filler** | 15.00 | **15.00** | **15.00** | **15.00** |
| **TiO₂** | 25.00 | **25.00** | **25.00** | **25.00** |
| **CaO** | - | **3.0** | **-** | **-** |
| **MgO** | - | **-** | **3.0** | **0.50** |
| **Talc** | 3.0 | **3.0** | **3.0** | **3.0** |
| **Stabilizers** | 1.2 | **1.2** | **1.2** | **1.2** |
| **Lubricant** | 0.5 | **0.5** | **0.5** | **0.5** |

### Reflectance measurements

Behavior of a part made from the inventive compositions in a LED device has been simulated by exposing samples under light (using an incandescent 400W 400 F/2 0338 lamp commercially available from Honle UV America Inc. with an Optivex™ UV filter of 3.3 mm commercially available from MH-Strahler) and high heat (using an oven set at 180°C for 12 days). These harsh conditions aim at reproducing the high power LED working environment.

Each one of the compositions of example E1-E3 and comparative example CE1 were used to prepare discs of about 50 mm diameter with a thickness of about 1.6 mm.

Reflectances were measured on a BKY-Gardner photo-spectrometer according to ASTM E-1331-09 using a D65 illuminant with a 10° observer. The average reflectance results on the original molded parts and on the same parts after exposure to high heat and light (for 3, 6 and 12 days) obtained on at least 3 samples are summarized in Table 2.

**Table 2 : Reflectance measurements on discs after heat and light treatment at 180°C**

| **Reflectance at 460 nm (%)** | (CE1) | (**E1)** | **(E2)** | **(E3)** |
|---|---|---|---|---|
| - as molded | 93 | **92** | **93** | **92** |
| - after 3 days at 180°C and light | 78 | **80** | **82** | **80** |
| - after 6 days at 180°C and light | 70 | **74** | **76** | **75** |
| - after 12 days at 180°C and light | 56 | **62** | **63** | **61** |

### Results

As it may be seen from the data presented in Table 2, the compositions according to the present invention (E1, E2 and E3) surprisingly show higher reflectance after exposure to high heat and light for 3, 6 and 12 days compared to the reflectances measured for comparative example CE1. Starting with comparable reflectances as molded, the comparative example CE1 presents a drop in reflectance already after 3 days of exposure to heat and light, while the compositions E1, E2 and E3 according to the present invention maintain a higher level in reflectance.

The presence of a metal oxide appears to play a crucial role in the heat and light resistance of the compositions.

Examples E1, E2 and E3 according to the present invention comply with a wide set of requirements as set forth previously (notably good processability, high dimensional stability, high mechanical strength) and also surprisingly feature a reflectance after high heat and light treatment. Those compositions are therefore excellent candidates for the manufacture of LED components.

## Claims

1. A polymer composition (C) comprising :
- at least one polyester (P) comprising at least 50 mol % of recurring units comprising at least one cycloaliphatic group,
- at least one inorganic additive (A) selected from the group consisting of TiO₂, ZnS and BaSO₄,
- from 0.2 to 10 wt.%, based on the total weight of the polymer composition (C), of at least one inorganic additive (B) selected from the group consisting of magnesium oxide, barium oxide, cerium oxide (IV) and calcium oxide.

2. Polymer composition (C) according to claim 1, wherein the polyester (P) is present in an amount of 45-60 wt. %, based on the total weight of the polymer composition (C).

3. Polymer composition (C) according to anyone of the preceding claims, wherein at least 50 mol % of the recurring units of the polyester (P) are obtained through the polycondensation of terephthalic acid with 1,4-cyclohexylenedimethanol.

4. Polymer composition (C) according to anyone of the preceding claims, wherein the polyester (P) is poly(1,4-cyclohexylenedimethylene terephthalate).

5. Polymer composition (C) according to anyone of the preceding claims, wherein the inorganic additive (A) is TiO₂.

6. Polymer composition (C) according to claim 5, wherein the TiO₂ is present in an amount of 10-40 wt. %, based on the total weight of the polymer composition (C)

7. Polymer composition (C) according to anyone of the preceding claims, wherein the inorganic additive (B) is magnesium oxide.

8. Polymer composition (C) according to anyone of claims 1-6, wherein the inorganic additive (B) is calcium oxide.

9. Polymer composition (C) according to anyone of the preceding claims, wherein the at least one inorganic additive (B) is present in an amount of 0.2 to 5 wt. %, based on the total weight of the polymer composition (C).

10. Polymer composition (C) according to anyone of the preceding claims, wherein it further comprises at least one reinforcing filler.

11. Polymer composition (C) according to claim 10, wherein the reinforcing filler is selected from the group consisting of glass fiber and wollastonite.

12. Polymer composition (C) according to claim 10, wherein the reinforcing filler is present in 5-40 wt. %, based on the total weight of the polymer composition (C).

13. An article comprising at least one part comprising the polymeric composition (C) according to any one of the preceding claims.

14. The article according to claim 13, said article is a part of a light emitting diode (LED) device.

## Patentansprüche

1. Polymerzusammensetzung (C), umfassend :
- mindestens einen Polyester (P), der mindestens 50 Mol-% Wiederholungseinheiten mit mindestens einer cycloaliphatischen Gruppe umfasst,
- mindestens ein anorganisches Additiv (A) aus der Gruppe bestehend aus TiO₂, ZnS und BaSO₄,
- 0,2 bis 10 Gew.-%, bezogen auf das Gesamtgewicht der Polymerzusammensetzung (C), mindestens eines anorganischen Additivs (B) aus der Gruppe bestehend aus Magnesiumoxid, Bariumoxid, Ceroxid(IV) und Calciumoxid.

2. Polymerzusammensetzung (C) nach Anspruch 1, wobei der Polyester (P) in einer Menge von 45-60 Gew.-%, bezogen auf das Gesamtgewicht der Polymerzusammensetzung (C), vorliegt.

3. Polymerzusammensetzung (C) nach einem der vorhergehenden Ansprüche, wobei mindestens 50 Mol-% der Wiederholungseinheiten des Polyesters (P) durch Polykondensation von Terephthalsäure mit 1,4-Cyclohexylendimethanol erhalten werden.

4. Polymerzusammensetzung (C) nach einem der vorhergehenden Ansprüche, wobei es sich bei dem Polyester (P) und Poly(1,4-cyclohexylendimethylenterephthalat) handelt.

5. Polymerzusammensetzung (C) nach einem der vorhergehenden Ansprüche, wobei es sich bei dem anorganischen Additiv (A) um TiO₂ handelt.

6. Polymerzusammensetzung (C) nach Anspruch 5, wobei das TiO₂ in einer Menge von 10-40 Gew.-%, bezogen auf das Gesamtgewicht der Polymerzusammensetzung (C), vorliegt.

7. Polymerzusammensetzung (C) nach einem der vorhergehenden Ansprüche, wobei es sich bei dem anorganischen Additiv (B) um Magnesiumoxid handelt.

8. Polymerzusammensetzung (C) nach einem der Ansprüche 1-6, wobei es sich bei dem anorganischen Additiv (B) um Calciumoxid handelt.

9. Polymerzusammensetzung (C) nach einem der vorhergehenden Ansprüche, wobei das mindestens eine anorganische Additiv (B) in einer Menge von 0,2 bis 5 Gew.-%, bezogen auf das Gesamtgewicht der Polymerzusammensetzung (C), vorliegt.

10. Polymerzusammensetzung (C) nach einem der vorhergehenden Ansprüche, wobei sie ferner mindestens einen verstärkenden Füllstoff umfasst.

11. Polymerzusammensetzung (C) nach Anspruch 10, wobei der verstärkende Füllstoff aus der Gruppe bestehend aus Glasfaser und Wollastonit ausgewählt ist.

12. Polymerzusammensetzung (C) nach Anspruch 10, wobei der verstärkende Füllstoff in einer Menge von 5-40 Gew.-%, bezogen auf das Gesamtgewicht der Polymerzusammensetzung (C), vorliegt.

13. Artikel, umfassend mindestens ein Teil, das die Polymerzusammensetzung (C) nach einem der vorhergehenden Ansprüche umfasst.

14. Artikel nach Anspruch 13, wobei der Artikel ein Teil einer Leuchtdioden(LED)-Vorrichtung ist.

## Revendications

1. Composition polymère (C) comprenant :
- au moins un polyester (P) comprenant au moins 50 % en moles de motifs récurrents comprenant au moins un groupe cycloaliphatique,
- au moins un additif inorganique (A) choisi dans le groupe constitué par TiO₂, ZnS et BaSO₄,
- de 0,2 à 10 % en poids, rapporté au poids total de la composition polymère (C), d'au moins un additif inorganique (B) choisi dans le groupe constitué par l'oxyde de magnésium, l'oxyde de baryum, l'oxyde de cérium (IV) et l'oxyde de calcium.

2. Composition polymère (C) selon la revendication 1, dans laquelle le polyester (P) est présent dans une quantité de 45-60 % en poids, rapporté au poids total de la composition polymère (C).

3. Composition polymère (C) selon l'une quelconque des revendications précédentes, dans laquelle au moins 50 % en moles des motifs récurrents du polyester (P) sont obtenus par la polycondensation d'acide téréphtalique avec du 1,4-cyclohexylènediméthanol. 1.

4. Composition polymère (C) selon l'une quelconque des revendications précédentes, dans laquelle le polyester (P) est le poly(téréphtalate de 1,4-cyclohexylènediméthylène).

5. Composition polymère (C) selon l'une quelconque des revendications précédentes, dans laquelle l'additif inorganique (A) est TiO₂.

6. Composition polymère (C) selon la revendication 5, dans laquelle le TiO₂ est présent dans une quantité de 10-40 % en poids, rapporté au poids total de la composition polymère (C).

7. Composition polymère (C) selon l'une quelconque des revendications précédentes, dans laquelle l'additif inorganique (B) est l'oxyde de magnésium.

8. Composition polymère (C) selon l'une quelconque des revendications 1 à 6, dans laquelle l'additif inorganique (B) est l'oxyde de calcium.

9. Composition polymère (C) selon l'une quelconque des revendications précédentes, dans laquelle l'au moins un additif inorganique (B) est présent dans une quantité de 0,2 à 5 % en poids, rapporté au poids total de la composition polymère (C).

10. Composition polymère (C) selon l'une quelconque des revendications précédentes, qui comprend en outre au moins une charge de renforcement.

11. Composition polymère (C) selon la revendication 10, dans laquelle la charge de renforcement est choisie dans le groupe constitué par la fibre de verre et la wollastonite.

12. Composition polymère (C) selon la revendication 10, dans laquelle la charge de renforcement est présente à 5-40 % en poids, rapporté au poids total de la composition polymère (C).

13. Article comprenant au moins une partie comprenant la composition polymère (C) selon l'une quelconque des revendications précédentes.

14. Article selon la revendication 13, ledit article étant une partie d'un dispositif à diode électroluminescente (DEL).
